# EUROPEAN PATENT APPLICATION

(11) **EP 4 057 341 A1**
(43) Date of publication of application: **14.09.2022**
(21) Application number: 21162409.3
(22) Date of filing: 12.03.2021
(51) Int. Cl.: H01L 23/495

(54) **PACKAGED HALF-BRIDGE CIRCUIT**

(71) Applicant: Nexperia B.V., 6534 AB Nijmegen (NL)
(72) Inventor: Yandoc, Ricardo, 6534 AB Nijmegen (NL)
(74) Representative: Pjanovic, Ilija

(57) **Abstract**

The present invention relates to a lead-frame based half-bridge package. The package comprises a die pad having a first surface and a second surface; a first semiconductor die arranged on the first surface of the die pad, the first semiconductor die having a first transistor integrated thereon that comprises a first terminal and a second terminal arranged at a first surface of the first semiconductor die, and a third terminal arranged at a second surface of the first semiconductor die, wherein the die pad is electrically connected to the drain terminal; a second semiconductor die having a second transistor integrated thereon that comprises a first terminal and a second terminal arranged at a first surface of the second semiconductor die, and a third terminal arranged at a second surface of the second semiconductor die, wherein the second surface of the second semiconductor die is arranged to face the first surface of the first semiconductor die.

The package further comprises a first contact element arranged on the first surface of the first semiconductor die and being electrically connected to the first terminal of the first transistor; a second contact element arranged in between the first and second semiconductor die and being electrically connected to the second terminal of the first transistor and the third terminal of the second transistor; a third contact element arranged on the first surface of the second semiconductor die and being electrically connected to the first terminal of the second transistor; and a fourth contact element arranged on the first surface of the second semiconductor die and being electrically connected to the second terminal of the second transistor.

## Description

The present invention relates to a lead-frame based half-bridge package. The present invention is particularly useful in power electronics applications, such as DC-DC converters and motor controllers.

A half-bridge circuit is an often used building block in various applications of power electronics, such as DC-DC converters or (H-bridge) motor controllers. For example, in a DC-DC converter, a half-bridge circuit may be used to control an output voltage of a transformer included in the DC-DC converter using two input switches included in the half-bridge circuit.

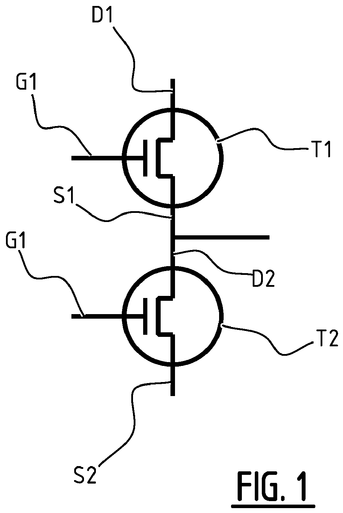

An example of a half-bridge circuit is shown in FIG. 1. The half-bridge circuit comprises a first transistor T1 and a second transistor T2, which are illustrated in FIG. 1 as field-effect transistors (FETs). However, a half-bridge circuit with bipolar junction transistors (BJTs), or a combination of a BJT and an FET, is also envisaged.

First transistor T1 has a gate terminal G1, a source terminal S1 and a drain terminal D1. Similarly, second transistor T2 has a gate terminal G2, a source terminal S2 and a drain terminal D2. In the half-bridge configuration, drain terminal D2 of second transistor T2 is electrically connected to source terminal S1 of first transistor T1. Gate terminals G1 and G2 may for example be referred to as (control) input terminals of the half-bridge circuit, while drain terminal D2 (and source terminal S1) forms an output terminal of the half-bridge circuit.

The half-bridge circuit of FIG. 1 can be realized as a physical component in various ways. For example, first transistor T1 and second transistor T2 may be integrated on a common semiconductor die, packaged in a semiconductor device package. Alternatively, first transistor T1 and second transistor T2 may be integrated on individual semiconductor dies that may each be individually packaged, or that are arranged inside a single package. In turn, the electrical connection between drain terminal D2 and source terminal S1 can be made internally, i.e., inside the package, or externally, for example by using conductive tracks on a printed circuit board (PCB).

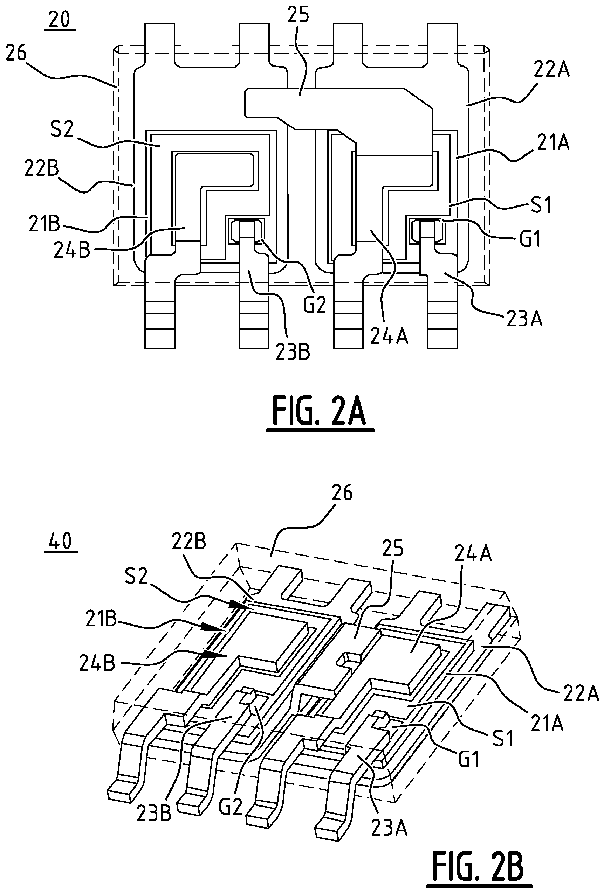

Examples of packaged half-bridge circuits known in the art are shown in FIGs. 2A and 2B. More in particular, FIG. 2A is a top-view of an exemplary half-bridge circuit package 20, and FIG. 2B is a perspective view of another exemplary half-bridge circuit package 40.

Package 20 of FIG. 2A comprises a first drain contact 22A (e.g., a die pad) on which a first semiconductor die 21A is arranged. First semiconductor die 21A has first transistor T1 integrated thereon that comprises drain terminal D1 (not shown) arranged at a bottom surface of first semiconductor die 21A, and gate and source terminal G1, S1 arranged at a top surface of first semiconductor die 21A. Furthermore, a first gate contact 23A and a first source contact 24A are provided on top of first semiconductor die 21A.

Similarly, package 20 further comprises a second drain contact 22B (e.g., another die pad) arranged next to first drain contact 22A and on which a second semiconductor die 21B is arranged. Second semiconductor die 21B has second transistor T2 integrated thereon that comprises drain terminal D2 (not shown) arranged at a bottom surface of second semiconductor die 21B, and gate and source terminal G2, S2 arranged at a top surface of second semiconductor die 21B. Furthermore, a second gate contact 23B and a second source contact 24B are provided on top of second semiconductor die 21B.

Package 20 further comprises a bridge connection 25 extending from first source contact 24A to a region on top of second drain contact 22B, thereby electrically connecting second drain contact 22B and first source contact 24A. Through bridge connection 25, source terminal S1 of first transistor T1 is electrically connected to drain terminal D2 of second transistor T2.

Semiconductor dies 21A and 21B, drain contacts 22A and 22B, gate contacts 23A and 23B, source contacts 24A and 24B, and bridge connection 25 are all encapsulated by a solidified moulding compound 26. Furthermore, each contact has one or more leads extending therefrom through and out of solidified moulding compound 26 to provide external access to corresponding terminals of first and second transistor T1, T2. Each contact may be integrally connected to its corresponding lead(s).

Package 40 shown in FIG. 2B differs from package 20 in FIG. 2A in that bridge connection 25 extends from a side of second drain contact 22B, rather than a top surface of second drain contact 22B. Consequently, there is no need for additional space on second drain contact 22B for bridge connection 25 to be connected at a top surface thereof.

A problem associated with the packaged half-bridge circuits known in the art is that the interconnection between drain terminal D2 of second transistor T2 and source terminal S1 of first transistor T1 is typically provided either externally to the package by electrically connecting the corresponding leads, or internally using a bridge connection. Said interconnection introduces an unwanted additional resistance and inductance to the half-bridge circuit that, in turn, degrade the performance of the circuit. Using a bridge connection may also substantially complicate the alignment of various elements of the package during the manufacturing process.

Furthermore, for power applications, a relatively low on-resistance of first transistor T1 and second transistor T2 is preferred. However, the on-resistance is strongly dependent on the die size, which in turn is limited by the maximum footprint of the package. In other words, for a given package footprint, the on-resistance performance of first transistor T1 and second transistor T2 is generally limited to the maximum corresponding die size in said package.

It is an object of the present invention to provide a packaged half-bridge circuit for which the abovementioned problems do not occur, or hardly so.

This object is achieved with the lead-frame based half-bridge package according to claim 1. The package comprises: a die pad having a first surface and a second surface; a first semiconductor die arranged on the first surface of the die pad, the first semiconductor die having a first transistor integrated thereon that comprises a first terminal and a second terminal arranged at a first surface of the first semiconductor die, and a third terminal arranged at a second surface of the first semiconductor die, wherein the die pad is electrically connected to the drain terminal; a second semiconductor die having a second transistor integrated thereon that comprises a first terminal and a second terminal arranged at a first surface of the second semiconductor die, and a third terminal arranged at a second surface of the second semiconductor die, wherein the second surface of the second semiconductor die is arranged to face the first surface of the first semiconductor die; a first contact element arranged on the first surface of the first semiconductor die and being electrically connected to the first terminal of the first transistor; a second contact element arranged in between the first and second semiconductor die and being electrically connected to the second terminal of the first transistor and the third terminal of the second transistor; a third contact element arranged on the first surface of the second semiconductor die and being electrically connected to the first terminal of the second transistor; a fourth contact element arranged on the first surface of the second semiconductor die and being electrically connected to the second terminal of the second transistor; and a solidified moulding compound encapsulating the first semiconductor die, the second semiconductor die and the first through fourth contact element. Each of the first through fourth contact element comprises one or more leads that extend from their respective contact element through and out of a side of the solidified moulding compound to provide external access to said contact element.

The second contact element, according to the present invention, is simultaneously used as a 'die pad' for the second semiconductor die, and a clip for the source terminal of the first semiconductor die, thereby eliminating the need for a bridge connection. Consequently, by stacking the first and second semiconductor die and interconnecting the first and second transistor using a shared second contact element as described above, a parasitic resistance and inductance associated with an interconnection between the first and second transistor is significantly reduced. Furthermore, the stacked configuration described above effectively reduces the package footprint, or enables increasing the size of both the first and second semiconductor die, thereby improving the on-resistance performance of the first and second transistor for a particular package footprint.

The solidified moulding compound may partially encapsulate the die pad. At least part of the second surface of the die pad may be exposed through the solidified moulding compound to provide external access to the third terminal of the first transistor. Alternatively, the package may further comprise one or more leads extending from the die pad, through and out of the solidified moulding compound to provide external access to said die pad.

The lead(s) of the first and second contact element may extend parallel to each other. For example, first and second contact element may have originated from different parts of a same clip comprised in a lead frame. Additionally or alternatively, the lead(s) of the third and fourth contact element may extend parallel to each other. For example, the third and fourth contact element may have originated from different parts of a same clip comprised in a lead frame.

At least one but preferably all of the first through fourth contact element may comprise a central planar part that is connected to one or more corresponding terminals of the first and second transistor and from which the one or more respective leads extend. For example, the clips and leads comprised in the lead frame may be substantially planar, thereby greatly simplifying the manufacturing process of the package, such as steps of aligning contact elements with respective semiconductor dies.

The leads corresponding to the first through fourth contact element may be gull-wing shaped such that an end thereof is positioned on a plane that coincides with a plane on which a bottom surface of the moulding compound and/or the second surface of the die pad is arranged.

The first transistor and the second transistor may each comprise a field-effect transistor (FET), wherein the first terminal is a gate terminal, wherein the second terminal is a source terminal, and wherein the third terminal is a drain terminal. Alternatively, the first transistor and the second transistor may each comprise a bipolar junction transistor (BJT), wherein the first terminal is a base terminal, wherein the second terminal is an emitter terminal, and wherein the third terminal is a collector terminal. In yet another alternative, one of the first transistor and the second transistor may be an FET, and another of the first transistor and the second transistor may be a BJT.

The first through fourth contact element may be attached and electrically connected to corresponding surfaces of the first and second semiconductor die using a conductive layer. For example, the conductive layer may comprise one of aluminium, copper, gold, silver and tin.

The fourth contact element may be at least partially exposed to an outside for allowing a heat sink or heat spreader to be connected to a surface of said fourth contact element.

The first transistor may be substantially identical to the second transistor. In some embodiments, the first semiconductor may be substantially identical to the second semiconductor die.

The first and/or second terminal of the first transistor may be arranged at opposing ends of the package with respect to the first and/or second terminal of the second transistor, respectively. In some embodiments, the one or more leads corresponding to the first contact element and the second contact element may extend in an opposite direction with respect to a direction in which the one or more leads corresponding to the third contact element and the fourth contact element extend.

According to another aspect of the present invention, a DC-DC converter is provided, comprising the packaged half-bridge circuit described above. According to yet another aspect of the present invention, a motor controller is provided, comprising the packaged half-bridge circuit described above.

Next, the present invention will be described with reference to the appended drawings, wherein:
FIG. 1 is a schematic of a half-bridge circuit;
FIGs. 2A and 2B are packaged half-bridge circuits known in the art;
FIG. 3 is a perspective view of a package according to an embodiment of the present invention;
FIG. 4 is an exploded view of a package according to an embodiment of the present invention; and
FIGs. 5A-5K illustrate a manufacturing process of a package according to an embodiment of the present invention.

Hereinafter, reference will be made to the appended drawings. It should be noted that identical reference signs may be used to refer to identical or similar components.

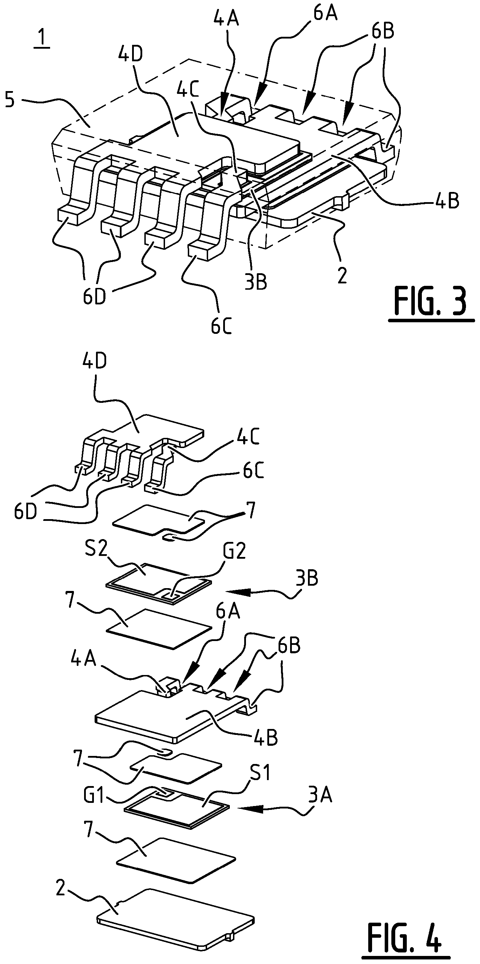

FIG. 3 shows a perspective view of a package 1 in accordance with an embodiment of the present invention, and FIG. 4 shows a corresponding exploded view of package 1.

Package 1 comprises a die pad 2 having a first surface and a second surface. A first semiconductor die 3A (not visible in FIG. 3) is arranged on top of the first surface of die pad 2. First semiconductor die 3A has first transistor T1 integrated thereon. First transistor T1 comprises a first terminal G1 and a second terminal S1 arranged at a top surface of first semiconductor die 3A, and a third terminal D1 (not shown) arranged at a bottom surface of first semiconductor die 3A. Die pad 2 is electrically connected to third terminal D1 of first transistor T1 using a conductive layer, for example a solder or sinter layer 7, and may form a contact for said terminal.

Furthermore, package 1 comprises a first contact element 4A and a second contact element 4B that are arranged on top of first semiconductor die 3A and are electrically connected, using for example a solder or sinter layer 7, to first terminal G1 and second terminal S1 of first transistor T1, respectively.

Package 1 further comprises a second semiconductor die 3B that is arranged on top of second contact element 4B. Second semiconductor die 3B has second transistor T2 integrated thereon. Second transistor T2 comprises a first terminal G2 and a second terminal S2 arranged at a top surface of second semiconductor die 3B, and a third terminal D2 (not shown) arranged at a bottom surface of second semiconductor die 3B. Second semiconductor die 3B is attached and electrically connected to second contact element 4B with its bottom surface, using a solder or sinter layer 7, such that third terminal D2 of second transistor T2 is electrically connected to second contact element 4B. In other words, second contact element 4B forms an electrical contact for both second terminal S1 of first transistor T1 and third terminal D2 of second transistor T2.

Furthermore, package 1 comprises a third contact element 4C and a fourth contact element 4D that are arranged on top of second semiconductor die 3B and that are electrically connected, using a solder or sinter layer 7, to first terminal G2 and second terminal S2 of second transistor T2, respectively.

The structure described above is encapsulated in a solidified moulding compound 5. In the embodiment shown in FIGs. 3 and 4, a lead 6A extends from and is integrally formed with first contact element 4A through and out of solidified moulding compound 5 and provides external access to first contact element 4A, and therefore also to first terminal G1 of first transistor T1. Similarly, leads 6B extend from and are integrally formed with second contact element 4B, a lead 6C extends from and is integrally formed with third contact element 4C, and leads 6D extend from and are integrally formed with fourth contact element 4D. Each lead 6A-6D extends through and out of solidified moulding compound 5, thereby providing external access to a respective contact element electrically connected with said lead, and to the respective terminal electrically connected with said respective contact element.

A portion of solidified moulding compound 5 may be omitted. For example, a bottom surface of die pad 2 may be exposed to an outside of package 1, such that said surface can serve as external access to die pad 2, and therefore to third terminal D1 of first transistor T1. Said bottom surface may also be attached to a heat sink or heat spreader (not shown), using thermal paste or the like, to remove heat from package 1 in operation. Similarly, a portion of solidified moulding compound 5 may be omitted such that a portion or surface of third contact element 4C and/or fourth contact element 4D are exposed to an outside of package 1.

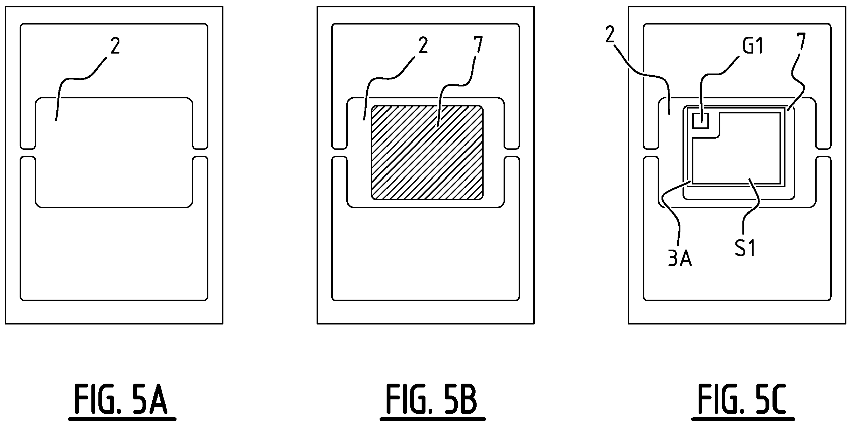

A process of manufacturing package 1 is described next with reference to FIGs. 5A-5K. As a first step, in FIG. 5A, die pad 2 is provided. For example, die pad 2 is comprised in a lead frame comprising a plurality of said die pads 2 for manufacturing a plurality of packages 1 simultaneously.

Next, in FIGs. 5B and 5C, first semiconductor die 3A is arranged on top of die pad 2. For example, as shown in FIG. 5B, a conductive layer 7, such as a solder layer or a sinter layer, may be used to attach first semiconductor die 3A to die pad 2 and to electrically connect die pad 2 to third terminal D1 of first transistor T1 integrated on first semiconductor die 3A.

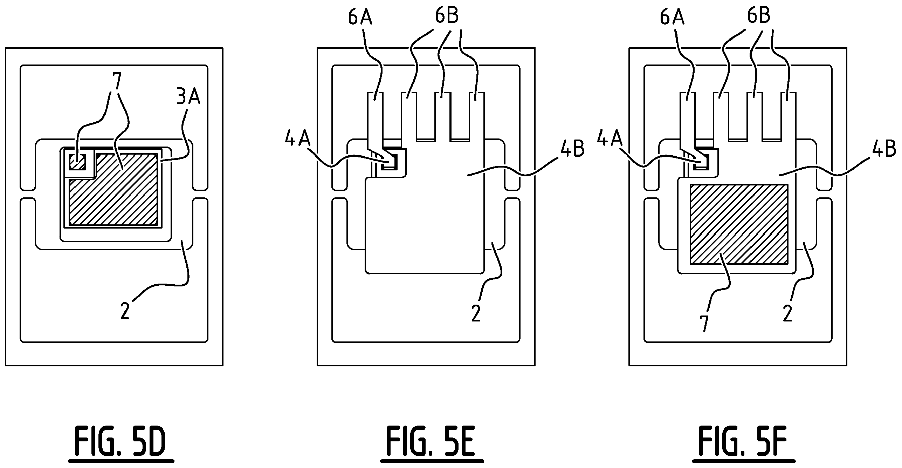

Then, in FIGs. 5D and 5E, first contact element 4A and second contact element 4B are attached on top of first semiconductor die 3A. More in particular, first contact element 4A is electrically connected to first terminal G1 of first transistor T1, and second contact element 4B is electrically connected to second terminal S1 of first transistor T1. First and second contact element 4A and 4B may for example be attached and electrically connected to first semiconductor die 3A using another conductive layer 7.

For example, first and second contact element 4A and 4B may be comprised in a lead frame that is aligned with first semiconductor die 3A to properly attach the contact elements. First and second contact element 4A and 4B may be referred to as clips, having one or more respective leads 6A and 6B which will eventually extend externally to the package to enable an external connection to first terminal G1 and second terminal S1 of first transistor T1, respectively. Alternatively, the aforementioned clips are singulated prior to arranging them on first semiconductor die 3A.

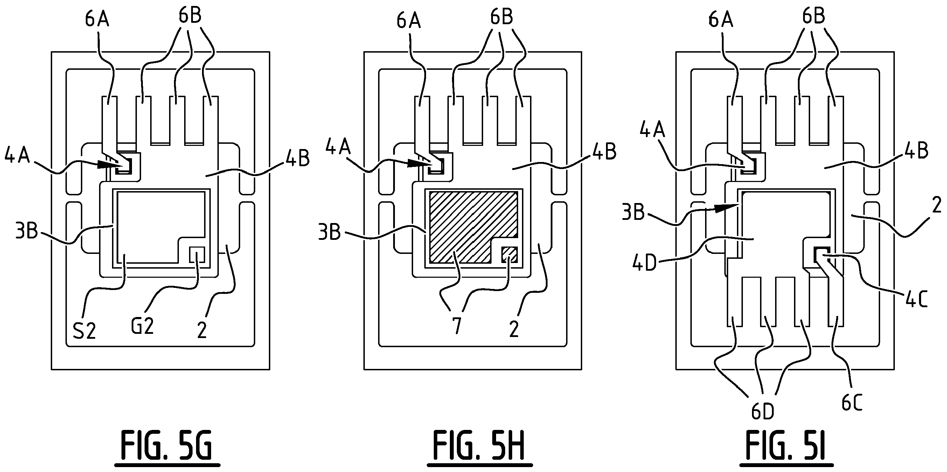

Following this, in FIGs. 5F and 5G, second semiconductor die 3B is arranged on top of second contact element 4B, and attached and electrically connected thereto using, for example, another conductive layer 7. More in particular, second contact element 4B is electrically connected to third terminal D2 of second transistor T2 that is integrated on second semiconductor die 3B, thereby electrically connecting said terminal to second terminal S1 of first transistor T1 that is integrated on first semiconductor die 3A.

Next, in FIGs. 5H and 5I, third contact element 4C and fourth contact element 4D are attached on top of second semiconductor die 3B. More in particular, third contact element 4C is electrically connected to first terminal G2 of second transistor T2, and fourth contact element 4D is electrically connected to second terminal S2 of second transistor T2. Third and fourth contact element 4C and 4D may for example be attached and electrically connected to the top surface of second semiconductor die 3B using another conductive layer 7.

For example, third and fourth contact element 4C and 4D may be comprised in a lead frame that is aligned with second semiconductor die 3B to properly attach the contact elements. Third and fourth contact element 4C and 4D may be referred to as clips, having one or more respective leads 6C and 6D which will eventually extend externally to the package to enable an external connection to first terminal G2 and second terminal S2 of second transistor T2, respectively. Alternatively, the aforementioned clips are singulated prior to arranging them on second semiconductor die 3B.

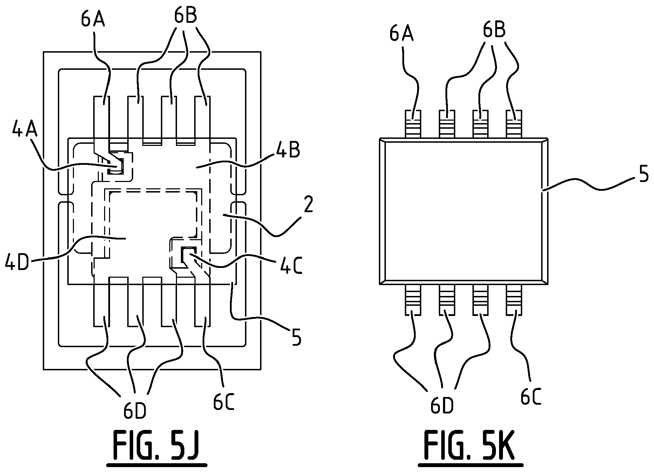

Referring to FIG. 5J, a moulding process is then used to encapsulate at least a portion of the above-described structure, for example using a moulding compound 5. Solidified moulding compound 5 may be arranged such that leads 6A-6D of each contact element 4A-4D extend through solidified moulding compound 5, while remaining components of package 1 are encapsulated by solidified moulding compound 5. A portion of solidified moulding compound 5 can be omitted, such that at least a portion of die pad 2 is exposed for providing an external contact to third terminal D1 of first transistor T1. Optionally, another portion of solidified moulding compound 5 is omitted such that at least a portion of third and/or fourth contact element 4C and 4D is exposed. In such configurations, said portion of third contact element 4C and/or fourth contact element 4D, and/or an exposed portion of die pad 2, may be attached to a heat sink or heat spreader (not shown), using thermal paste or the like, to remove heat from package 1 in operation.

Finally, in FIG. 5K, the structure is singulated from the lead frame in which die pad 2 is comprised to obtain package 1. In this step, or prior to this step, leads 6A-6D are formed into a gull-wing shaped lead by means of a bending step.

In some embodiments, second semiconductor die 3B is identical to first semiconductor die, or has a similar transistor terminal layout. In that case, the first and/or second terminal G1, S1 of first transistor T1 may be arranged at opposing ends of package 1 with respect to first and/or second terminal G1, S1 of second transistor T2, respectively. For example, first terminal G1 of first transistor T1 is arranged at the first surface of first semiconductor die 3A at an opposing end of package 1 with respect to first terminal G2 of second transistor T2. Leads 6A, 6B corresponding to first and second contact element 4A, 4B may then extend in a direction opposite to a direction in which leads 6C, 6D corresponding to third and fourth contact element 4C, 4B extend. This provides an efficiently packaged half-bridge circuit having a balanced orientation of leads on opposing sides of the package.

The embodiments discussed above are in the art referred to as loss-free packages, i.e., LFPAKs, or small outline packages, i.e., SOTs.

In the above, the present invention has been explained using detailed embodiments thereof. However, it should be appreciated that the invention is not limited to these embodiments and that various modifications are possible without deviating from the scope of the present invention as defined by the appended claims.

## Claims

1. A lead-frame based half-bridge package (1), comprising:
a die pad (2) having a first surface and a second surface;
a first semiconductor die (3A) arranged on the first surface of the die pad (2), the first semiconductor die (3A) having a first transistor (T1) integrated thereon that comprises a first terminal (G1) and a second terminal (S1) arranged at a first surface of the first semiconductor die (3A), and a third terminal (D1) arranged at a second surface of the first semiconductor die (3A), wherein the die pad (2) is electrically connected to the drain terminal (D1);
a second semiconductor die (3B) having a second transistor (T2) integrated thereon that comprises a first terminal (G2) and a second terminal (S2) arranged at a first surface of the second semiconductor die (3B), and a third terminal (D2) arranged at a second surface of the second semiconductor die (3B), wherein the second surface of the second semiconductor die (3B) is arranged to face the first surface of the first semiconductor die (3A);
a first contact element (4A) arranged on the first surface of the first semiconductor die (3A) and being electrically connected to the first terminal (G1) of the first transistor (T1);
a second contact element (4B) arranged in between the first and second semiconductor die (3A, 3B) and being electrically connected to the second terminal (S1) of the first transistor (T1) and the third terminal (D2) of the second transistor (T2);
a third contact element (4C) arranged on the first surface of the second semiconductor die (3B) and being electrically connected to the first terminal (G2) of the second transistor (T2);
a fourth contact element (4D) arranged on the first surface of the second semiconductor die (3B) and being electrically connected to the second terminal (S2) of the second transistor (T2); and
a solidified moulding compound (5) encapsulating the first semiconductor die (3A), the second semiconductor die (3B) and the first through fourth contact element (4A-4D),
wherein each of the first through fourth contact element (4A-4D) comprises one or more leads (6A-6D) that extend from their respective contact element (4A-4D) through and out of a side of the solidified moulding compound (5) to provide external access to said contact element (4A-4D).

2. The package (1) according to claim 1, wherein the solidified moulding compound (5) partially encapsulates the die pad (2), wherein at least part of the second surface of the die pad (2) is exposed through the solidified moulding compound (5) to provide external access to the third terminal (D1) of the first transistor (T1).

3. The package (1) according to claim 1 or 2, wherein the package (1) further comprises one or more leads extending, from the die pad (2), through and out of the solidified moulding compound (5) to provide external access to said die pad (2).

4. The package (1) according to any of the previous claims, wherein the leads of the first and second contact element (4A, 4B) extend parallel to each other, and preferably originated from different parts of a same clip comprised in a lead frame.

5. The package (1) according to any of the previous claims, wherein the leads of the third and fourth contact element (4C, 4D) extend parallel to each other, and preferably originated from different parts of a same clip comprised in a lead frame.

6. The package (1) according to any of the previous claims, wherein at least one but preferably all of the first through fourth contact element (4A-4D) comprises a central planar part that is connected to one or more corresponding terminals of the first and second transistor (T1, T2) and from which the one or more respective leads (6A-6D) extend.

7. The package (1) according to any of the previous claims, wherein the leads (6A-6D) corresponding to the first through fourth contact element (4A-4D) are gull-wing shaped formed such that an end thereof is positioned on a plane that coincides with a plane on which a bottom surface of the moulding compound (5) or, in so far as depending on claim 2, the second surface of the die pad (2) is arranged.

8. The package (1) according to any of the previous claims, wherein the first transistor (T1) and the second transistor (T2) comprise field-effect transistors, FETs, wherein the first terminal (G1; G2) is a gate terminal, wherein the second terminal (S1; S2) is a source terminal, and wherein the third terminal (D1; D2) is a drain terminal; or
wherein the first transistor (T1) and the second transistor (T2) comprise bipolar junction transistors, BJTs, wherein the first terminal (G1; G2) is a base terminal, wherein the second terminal (S1; S2) is an emitter terminal, and wherein the third terminal (D1; D2) is a collector terminal; or
wherein one of the first transistor (T1) and the second transistor (T2) is an FET, and another of the first transistor (T1) and the second transistor (T2) is a BJT.

9. The package (1) according to any of the previous claims, wherein each of the first through fourth contact element (4A-4D) is attached to corresponding surfaces of the first and second semiconductor die (3A, 3B) using a conductive layer (7),
wherein the conductive layer (7) preferably comprises one of aluminium, copper, gold, silver and tin.

10. The package (1) according to any of the previous claims, wherein the fourth contact element (4D) is at least partially exposed to an outside for allowing a heat sink or heat spreader to be connected to a surface of said fourth contact element (4D).

11. The package (1) according to any of the previous claims, wherein the first transistor (T1) is substantially identical to the second transistor (T2).

12. The package (1) according to any of the previous claims, wherein the first semiconductor die (3A) is substantially identical to the second semiconductor die (3B).

13. The package (1) according to any of the previous claims, wherein the first and/or second terminal of the first transistor (T1) are arranged at opposing ends of the package (1) with respect to the first and/or second terminal of the second transistor (T2), respectively,
wherein the one or more leads (6A, 6B) corresponding to the first contact element (4A) and the second contact element (4B) preferably extend in a direction opposite to a direction in which the one or more leads (6C, 6D) corresponding to the third contact element (4C) and the fourth contact element (4D) extend.

14. A DC-DC converter comprising a packaged half-bridge circuit according to any of the previous claims.

15. A motor controller comprising a packaged half-bridge circuit according to any of the claims 1-13.
